# EUROPÄISCHE PATENTSCHRIFT

(11) **EP 0 303 945 B1**
(45) Veröffentlichungstag und Bekanntmachung des Hinweises auf die Patenterteilung: **24.11.1993**
(21) Anmeldenummer: 88112935.7
(22) Anmeldetag: 09.08.1988
(51) Int. Cl.: G03F 7/022

(54) **Lichtempfindliches Gemisch auf Basis von 1,2-Naphthochinondiaziden und hiermit hergestelltes Kopiermaterial**
Photosensitive composition based on 1,2-naphthoquinone diazides, and copying material prepared therefrom
Composition photosensible à base de 1,2-naphtoquinonediazides et matériel pour l'enregistrement fabriqué avec cette composition

(30) Priorität: 18.08.1987 DE 3727443
(43) Veröffentlichungstag der Anmeldung: 22.02.1989
(73) Patentinhaber: HOECHST AKTIENGESELLSCHAFT, 65926 Frankfurt am Main (DE)
(72) Erfinder: Stahlhofen, Paul, Dr., Dipl.-Chem., D-6200 Wiesbaden (DE); Erdmann, Fritz, Dr., Dipl.-Chem., D-6228 Eltville 4 (DE)

(56) Entgegenhaltungen:
- DE-A- 2 641 100
- US-A- 4 758 497

## Beschreibung

Die Erfindung betrifft ein lichtempfindliches Gemisch, das im wesentlichen einen Naphthochinondiazidsulfonsäureester, ein in wäßrig-alkalischen Lösungen lösliches, harzartiges Bindemittel und einen zur Salzbildung befähigten organischen Farbstoff enthält. Die Erfindung betrifft auch ein hiermit hergestelltes Kopiermaterial.

Es ist bereits eine große Zahl von lichtempfindlichen, positiv arbeitenden Materialien bekannt. Am meisten bearbeitet und technisch genutzt sind die 1,2-Naphthochinondiazide, beschrieben in Kosar, Light Sensitive Systems, Wiley, New York (1965), Seiten 339-353, die vorzugsweise in Kombination mit Novolak-Harzen als Kopierschichten und Kopierlacke vielfältige Anwendung finden. In den letzten Jahren wurden weitere Positiv-Systeme vorgeschlagen: The Journal of Photographic Science 18 (1971), Seite 88; DE-A 21 50 691 entsprechend US-A 3 849 137 und DE-A 22 42 106 entsprechend US-A 3 901 710, bei denen ebenfalls photolytisch erzeugte saure hydrophile Gruppen die alkalische Entwickelbarkeit zu einem positiven Bild ermöglichen.

Die an sich gelb gefärbten 1,2-Naphthochinondiazid-Schichten bleichen bei der Belichtung zu einem gelblich gefärbten Lichtzersetzungsprodukt aus, wodurch die nicht vom Licht zersetzten Schichtanteile (Bildstellen) und die Lichtzersetzungsprodukte (Nichtbildstellen) nur schwer visuell zu unterscheiden sind. Dies führt in der Praxis sehr oft zu Fehlkopien, vor allem bei der Belichtung in den sogenannten Repetier-Kopiermaschinen, in denen ein einziges Diapositiv, z.B. für den Etikettendruck, mehrfach nebeneinander auf die Druckplatte projiziert wird. Da der Kontrast zwischen Bild- und Nichtbildstellen auf der Druckplatte nach dem Belichten nur schwach ist, insbesondere bei ihrer Betrachtung in Gegenwart von gelbem Licht, wie es in den Kopierräumen bei der Verarbeitung von lichtempfindlichen Druckplatten erforderlich ist, kann es beispielsweise sehr schwierig sein, genaue und platzsparende Einpaß-Arbeiten durchzuführen.

Diesen Nachteil kann man bekanntlich dadurch beseitigen, daß man der lichtempfindlichen Schicht einen farbigen organischen Indikator-Farbstoff in homogener Verteilung zugibt, der im pH-Bereich zwischen 2,5 und 6,5 seine Farbe wechselt, sofern infolge einer photochemischen Reaktion eine ausreichende Säurebildung erfolgt.

Die beim Belichten von bisher bekannten 1,2-Naphthochinondiaziden entstehende Indencarbonsäure reicht in diesem Sinne zumeist nur ungenügend für eine ausreichende bildmaßige Differenzierung aus. Um diesen Nachteil zu überwinden, wurde bereits vorgeschlagen, zusätzlich zur Naphthochinondiazid haltigen Kopierschicht spezielle photochemische Säurebildner hinzuzugeben, wodurch in Gegenwart geeigneter Farbstoffe an den belichteten Schichtbereichen eine Farbänderung eintritt. Derartige strahlungsempfindliche Komponenten, die beim Bestrahlen mit Licht oder Elektronen ausreichender Energie Säure abspalten, sind beispielsweise bestimmte Diazoniumsalze oder photochemische Halogenverbindungen sowie Chinondiazidsulfochloride. Geeignete Diazoniumsalze werden in DE-A 26 41 099 und 26 41 100 entsprechend US-A 4 163 672 und 4 160 671 beschrieben und werden in Form ihrer organischen löslichen Salze, meist als Abscheidungsprodukte mit komplexen Säuren wie Borfluorwasserstoffsäure oder Hexafluorphosphorsäure, eingesetzt. Geeignete Chinondiazidsulfonsäurechloride werden in DE-A 23 31 377 entsprechend US-A 3 969 118 beschrieben. Bevorzugt wird aus dieser Gruppe das 1,2-Naphthochinondiazid-4-sulfonsäurechlorid. Als halogenhaltige strahlungsempfindliche und Halogenwasserstoffsäure bildende Verbindung eignen sich vor allem die als photochemische Radikalstarter für photopolymersierbare Massen bekannten organischen Halogenverbindungen, beispielsweise solche mit mehr als einem Halogenatom an einem Kohlenstoffatom oder einem aromatischen Ring. Beispiele sind in den US-A 3 565 624, 3 515 552 und 3 536 489 und der DE-A 22 43 621 entsprechend US-A 39 54 475 beschrieben.

Photochemische Säurebildner der angegebenen Verbindungsklassen, die der lichtempfindlichen Kopierschicht zugesetzt werden müssen, führen jedoch mehr oder weniger zu bestimmten kopier- und drucktechnischen Nachteilen. Entweder ist der nach der bildmäßigen Belichtung resultierende Bildkontrast bei gelbem Sicherheitslicht nicht ausreichend oder die Lichtempfindlichkeit oder die Haltbarkeit der Kopierschicht werden nachteilig beeinflußt.

Der Erfindung lag die Aufgabe zugrunde, ein positiv arbeitendes lichtempfindliches Gemisch zur Verfügung zu stellen, das sowohl nach der bildmäßigen Belichtung einen auch bei gelbem Sicherheitslicht deutlich sichtbaren Farbkontrast zwischen den belichteten und unbelichteten Schichtbereichen besitzt, als auch nach der Entwicklung einen deutlichen Kontrast zwischen der Druckschablone und dem Schichtträger aufweist, ohne daß die geschilderten kopiertechnischen Nachteile der Lichtempfindlichkeit oder der Haltbarkeit, wie sie durch den Zusatz bestimmter photochemischer Säurebildner zur Kopierschicht verursacht werden, auftreten.

Die Lösung dieser Aufgabe geht aus von einem lichtempfindlichen Gemisch der eingangs genannten Art und sie ist dadurch gekennzeichnet, daß es einen 1,2-Naphthochinondiazidsulfonsäureester der allgemeinen Formel 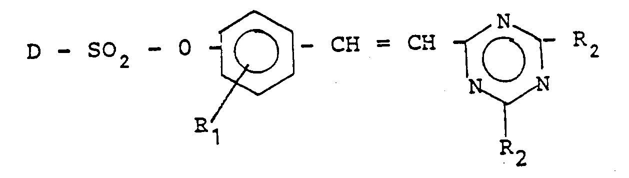
enthält, worin
- D: 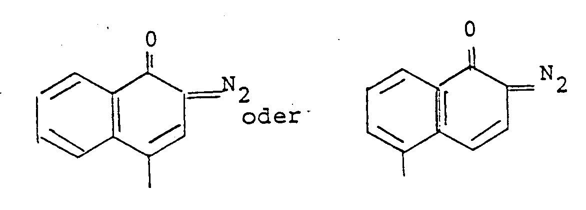
- R₁: Wasserstoff, NO₂, Alkyl, Alkoxy mit jeweils bis zu 4 Kohlenstoffatomen, Halogen und/oder -O-SO₂-D und
- R₂: einen Trihalogenalkylrest
bedeuten.

Vorzugsweise entspricht der 1,2-Naphthochinondiazidsulfonsäureester einer Verbindung der allgemeinen Formel, worin
- R₁: Wasserstoff, NO₂, Alkyl, Alkoxy, mit jeweils 1 oder 2 Kohlenstoffatomen, Chlor und/oder Brom und
- R₂: Trichlormethyl
bedeuten.

Die in dem erfindungsgemäßen Gemisch enthaltenen 1,2-Naphthochinondiazide werden in Analogie zu bekannten Verfahren durch Veresterung der phenolischen Hydroxygruppe der Grundkörper mit 1,2-Naphthochinondiazidsulfonsäuren oder deren reaktionsfähigen Derivaten, zum Beispiel den Sulfonsäurechloriden, hergestellt.

Die entsprechenden Grundkörper, die 2-(Hydroxyarylethenyl)-4,6-bis-(trihalogenmethyl)-s-triazine, werden durch Kondensation von 2,4-Bis-(trihalogenmethyl)-6-methyl-s-triazin mit bestimmten aromatischen Hydroxyaldehyden in Gegenwart von Piperidinacetat als Katalysator erhalten.

Die Herstellung der 2,4-Bis-(trihalogenmethyl)-6-methyl-s-triazine erfolgt am vorteilhaftesten nach der Vorschrift von Wakabayashi et al., Bulletin of the Chemical Society of Japan, 42 (1969) S. 2924-2930.

Die Konzentration der erfindungsgemäßen 1-2-Naphthochinondiazidsulfonsäureester in dem lichtempfindlichen Gemisch kann in relativ weiten Grenzen schwanken. Im allgemeinen liegt der Anteil zwischen 1 und 30 Gewichtsprozent, bezogen auf das Gewicht des Feststoffanteils des lichtempfindlichen Gemisches.

Das erfindungsgemäße lichtempfindliche Gemisch enthält ferner ein polymeres, wasserunlösliches harzartiges Bindemittel, das sich in den verwendeten Lösungsmitteln löst und in wäßrigen Alkalien ebenfalls löslich oder zumindest quellbar ist.

Die bei vielen Positiv-Kopiermaterialien auf Basis von 1,2-Naphthochinondiaziden bewährten Novolak-Kondensationsharze haben sich als Bindemittel auch hier als vorteilhaft erwiesen. Die Novolake können zusätzlich in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel können Polyhydroxyphenylharze, die durch Kondenstaion aus Phenolen und Aldehyden oder Ketonen hergestellt werden, Mischpolymerisate aus Styrol und Maleinsäureanhydrid, Polyvinylphenole oder Mischpolymerisate der Acrylsäure oder Methacrylsäure, insbesondere Polymerisate bzw. Copolymerisate aus Acryl-oder Methacrylsäurephenylestern, eingesetzt werden. Die Art und Menge des alkalilöslichen Bindemittels kann je nach Anwendungszweck verschieden sein; bevorzugt werden Anteile am Gesamtfeststoff zwischen 90 und 39, insbesondere 85 - 55 Gewichtsprozent verwendet.

Zusätzlich können noch zahlreiche andere Harze mitverwendet werden, wie Epoxyharze und Vinylpolymerisate, wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und nach dem Einfluß auf die Entwicklungsbedingungen und beträgt im allgemeinen nicht mehr als 50, bevorzugt etwa 2 bis 35 Gewichtsprozent, vom alkalilöslichen Bindemittel. In geringen Mengen kann das lichtempfindliche Gemisch für spezielle Erfordernisse, wie Flexibilität, Haftung, Glanz und Färbung, außerdem noch Substanzen wie Polyglykole, Cellulosederivate, wie Ethylcellulose, Netzmittel, Farbstoffe, Haftvermittler und feinteilige Pigmente sowie bei Bedarf UV-Absorber enthalten.

Als geeignete zur Salzbildung befähigte organische Farbstoffe werden besonders basische Farbstoffe aus der Gruppe der Triphenylmethane, d.h. solche, die sich von Triphenylmethan durch Substitution des Phenylrestes durch NH₂-, OH-, HSO₃- oder andere Gruppen oder Atome ableiten, oder solche aus der Gruppe der Azine, wie Phenazine, Oxazine oder Azofarbstoffe oder Farbstoffe aus der Gruppe der Anthrachinone verwendet. Beispielsweise seien genannt: Kristallviolett (C.I. 42 555), Methyl-violett 2 B (C.I. 42 535), Malachitgrün (C.I. 42 000), Fuchsin (C.I. 42 510), Kristallviolettcarbinolbase (C.I.42 555:1), Parafuchsin (C.I. 42 500), Sudanblau G (C.I. 61 520), Acilanbrillantblau 5 B (C.I. 42 740), Acilanviolett S 4 BN (C.I. 42 640), Astradiamantgrün GX (C.I. 42 040), Rhodamin B (C.I. 45 170), Samaronblau GSL (C.I. 62 500), Viktoriablau B (C.I. 44 045), Alizarindirektblau (C.I. 62 055), Viktoriareinblau BOD (C.I. 42 595), Brillantgrün (C.I. 42 040), Nilblau BX (C.I. 51 185), Neutralrot (C.I. 50 040) und Rhodulinreinblau 3 G (C.I. 51 004). Die in Klammern stehenden Zahlen bedeuten dabei die "Constitution Number", die in dem fünfbändigen Werk "Colour Index" 3. Auflage (1971, London) zur Identifizierung der Farbstoffe verwendet wird.

Am deutlichsten ist der gewünschte bildmäßige Farbkontrast der belichteten Schicht dann, wenn der in ihr enthaltene Farbstoff rot, blau oder grün ist. Solche Farbstoffe werden erfindungsgemäß bevorzugt verwendet.

Die Erfindung betrifft auch ein Kopiermaterial aus einem Schichtträger und einer lichtempfindlichen Schicht, die das erfindungsgemäße Gemisch enthält oder daraus besteht.

Zur Beschichtung eines geeigneten Schichtträgers wird das lichtempfindliche Gemisch im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether, wie Tetrahydrofuran, Alkoholether wie Ethylenglykolmonoalkylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmethylether werden besonders bevorzugt.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat, vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag. Belichtet wird mit den in der Technik üblichen Lichtquellen.

Zum Entwickeln werden wäßrig-alkalische Lösungen abgestufter Alkalität verwendet, vorzugsweise mit einm pH im Bereich von 10 - 14, die auch kleine Mengen organischer Lösungs- oder Netzmittel enthalten können.

Zur Herstellung einer positiven Druckform wird das lichtempfindliche Material unter einer Positiv-Vorlage bildmäßig belichtet und anschließend mittels eines wäßrigalkalischen Entwicklers entwickelt. Zur bildmäßigen Belichtung können die üblichen Kopiergeräte wie Röhrenlampen, Xenonimpulslampen, metall-halogeniddotierte Quecksilberdampflampen oder Kohlenbogenlampen verwendet werden.

Die unter Verwendung der erfindungsgemäßen 1,2-Naphthochinondiazide hergestellten Kopierschichten ergeben, auf einen geeigneten Schichtträger aufgebracht, nach dem Belichten unter einer Filmvorlage einen ausgezeichneten Bildkontrast zwischen den belichteten und den nicht belichteten Schichtbereichen, der auch bei gelbem Licht deutlich sichtbar ist. Nach dem Entwickeln bleibt die Farbe erhalten, so daß auch die resultierende Druckschablone sich deutlich vom Schichtträger abhebt.

Der Vorteil der erfindungsgemäß hergestellten lichtempfindlichen Gemische liegt darin, daß als lichtempfindliche Verbindungen 1,2-Naphthochinondiazide eingesetzt werden, die nicht nur eine hohe praktische Lichtempfindlichkeit haben, sondern vor allem darin, daß beim Belichten neben der aus dem Naphthochinondiazid entstehenden Indencarbonsäure aus den anwesenden Trihalogenalkylgruppen noch weitere Säuren gebildet werden, so daß ein relativ großer Säure-Verstärkungsfaktor entsteht, der zu einer starken Farbänderung des in der Schicht verwendeten Indikator-Farbstoffs beiträgt, was schließlich zu dem ausgezeichneten Bildkontrast nach dem Belichten führt. Vorteilhaft ist auch, daß das erfindungsgemäße 1,2-Naphthochinondiazid gegebenenfalls auch als Säurespender lichtempfindlichen Formulierungen zugesetzt werden kann. Nach der Entfernung der belichteten Teile durch Entwickeln ist eine ebenfalls kontrastreich gefärbte Schablone entsprechend der Belichtungsvorlage zu sehen. Hierdurch werden mitkopierte Filmkanten und Paßkreuze, die nach der Entwicklung entfernt bzw. korrigiert werden müssen, deutlicher sichtbar.

Auf das Einfärben mitkopierter Filmränder zwecks besserer Sichtbarmachung kann daher verzichtet werden. Ein weiterer Vorteil des erfindungsgemäßen lichtempfindlichen Gemisches ist, daß infolge der beim Belichten der erfindungsgemäßen 1,2-Naphthochinondiazide entstehenden relativ starken Säuren es nicht mehr notwendig ist, der Kopierschicht zusätzlich noch einen speziellen photolytischen Säurebildner hinzuzufügen, der im allgemeinen zu bestimmten kopiertechnischen Nachteilen, wie zum Beispiel Verschlechterung der Lichtempfindlichkeit oder Lagerfähigkeit, der Kopierschicht bzw. Druckplatte führt.

Die Erfindung wird anhand der nachfolgenden Beispiele erläutert.

### Beispiel 1:

Mit einer Lösung von
1,400 Gt (Gewichtsteile) des Veresterungsproduktes aus 1 Mol 2-(4-Hydroxyphenylethenyl)-4,6-bis-(trichlormethyl)-s-triazin und 1 Mol Naphthochinon-(1,2)-diazid-(2)-5-sulfonsäurechlorid,
6,600 Gt eines Kresol-Formaldehyd-Novolaks mit einem Erweichungspunkt von 127 - 145 °C,
0,070 Gt Kristallviolett (Triphenylmethanfarbstoff) in
40,00 Gt Ethylenglykolmonomethylether und
60,00 Gt Tetrahydrofuran
wurde eine elektrochemisch aufgerauhte und anodisierte Aluminiumplatte beschichtet. Der anodisierte Träger war vor dem Aufbringen der lichtempfindlichen Kopierschicht mit einer wäßrigen Lösung von 0,1 Gewichtsprozent Polyvinylphosphonsäure behandelt worden.

Das so erhaltene lichtempfindliche Kopiermaterial mit einem Schichtgewicht von ca. 2,30 g/m² hatte eine stark dunkelblau gefärbte Kopierschicht. Nach der Belichtung unter einer transparenten Positiv-Vorlage mit Hilfe einer Metall-Halogenid-Lampe von 500 Watt bei einem Lampenabstand von 103 cm mit 55 Takten blieben die unbelichteten Bereiche der Schicht kräftig blau gefärbt, während die belichteten Bereiche der Schicht nur noch schwach gefärbt bis nahezu farblos waren. Man sah daher das Bild der Vorlage in gutem Kontrast, so daß es auch bei gelber Beleuchtung in allen Einzelheiten deutlich sichtbar war.

Zur Herstellung einer Druckform wurde die belichtete Druckplatte mit einer 5% igen Natriumsilikatlösung entwickelt, wodurch die belichteten Schichtbereiche entfernt wurden. Die zurückgebliebenen nicht belichteten Schichtbereiche waren mit gutem Kontrast zur ungefärbten Druckträgeroberfläche sichtbar.

In den folgenden Beispielen wurde in entsprechender Weise wie im obigen Beispiel verfahren, und es wurden nach dem Belichten der erhaltenen lichtempfindlichen Druckplatten hinsichtlich Bildkontrast, sowohl vor wie auch nach dem Entwickeln, im wesentlichen entsprechende Resultate erhalten. Es werden daher für die folgenden Beispiele nur die Rezepturen der Beschichtungslösungen, die Art der verwendeten Sensibilisatoren und der eingesetzten Farbstoffe sowie der Farbumschlag nach dem Belichten angegeben.

### Beispiel 2

### Beschichtungslösung:

1,400 Gt des Veresterungsproduktes aus 1 Mol 2-(3-Nitro-4-hydroxyphenylethenyl)-4,6-bis-(trichlormethyl)- s-triazin und 1 Mol Naphthochinon-(1,2)-diazid-(2)-5-sulfonsäurechlorid,
0,100 Gt Sudanblau G (Anthrachinonfarbstoff),
6,000 Gt Novolak wie im Beispiel 1,
100,00 Gt Lösungsmittelgemisch wie im Beispiel 1.

Farbumschlag nach dem Belichten: Von grün nach hellbraun.

### Beispiel 3

### Beschichtungslösung:

1,400 Gt des Veresterungsproduktes aus 1 Mol 2-(4-Hydroxyphenylethenyl)-4,6-bis-(trichlormethyl)-s-triazin und 1 Mol Naphthochinon-(1,2)-diazid-(2)-4-sulfonsäurechlorid,
0,100 Gt Neutralrot (Azinfarbstoff)
6,600 Gt Novolak wie im Beispiel 1,
100,00 Gt Lösungsmittelgemisch wie im Beispiel 1.

Farbumschlag nach dem Belichten: Von rot nach dunkelblau.

### Beispiel 4

### Beschichtungslösung:

1,400 Gt des Veresterungsproduktes aus 1 Mol 2-(3-Methoxy-4-hydroxyphenylethenyl)-4,6-bis-(trichlormethyl)-s-triazin und 1 Mol Naphthochinon(1,2)-diazid-(2)-5-sulfonsäurechlorid,
0,100 Gt eines dunkelblauen Azofarbstoffes, erhalten durch Kuppeln von 2,4-Dinitro-6-chlor-benzoldiazoniumsalz mit 2,5-Dimethoxy-N,N-diethylanilin,
6,600 Gt Novolak wie im Beispiel 1,
100,00 Gt Lösungsmittelgemisch wie im Beispiel 1.

Farbumschlag nach dem Belichten: Von dunkelblau nach gelbbraun.

### Beispiel 5

### Beschichtungslösung:

1,400 Gt des Veresterungsproduktes aus 1 Mol 2-(2-Hydroxy-3,5-dibromphenylethenyl)-4,6-bis-(trichlormethyl)-s-triazin und 1 Mol Naphthochinon-(1,2)-diazid-(2)-5-sulfonsäurechlorid,
0,120 Gt Viktoriareinblau BOD (Triphenylmethanfarbstoff),
6,600 Gt Copolymerisat aus Brenzcatechinmethacrylsäureester und Styrol im Molverhältnis 70:30
100,00 Gt Lösungsmittelgemisch wie im Beispiel 1.

Farbumschlag nach dem Belichten: Von blau nach hellblau bis farblos.

### Beispiel 6

### Beschichtungslösung:

1,400 Gt des Veresterungsproduktes aus 1 Mol 2-(3-Methoxy-4-hydroxyphenylethenyl)-4,6-bis-(trichlormethyl)-s-triazin und 1 Mol Naphthochinon-(1,2)-diazid-(2)-4-sulfonsäurechlorid,
0,080 Gt Nilblau BX (Oxazinfarbstoff),
6,600 Gt Novolak wie im Beispiel 1,
100,00 Gt Lösungsmittelgemisch wie im Beispiel 1.

Farbumschlag nach dem Belichten: Von dunkelgrün nach hellblau.

### Beispiel 7

### Beschichtungslösung:

1,400 Gt des Veresterungsproduktes aus 1 Mol 2,3,4-Trihydroxybenzophenon und 3 Mol Naphthochinon(1,2)-diazid-(2)-5-sulfonsäurechlorid,
6,600 Gt eines Kresol-Formaldehyd-Novolaks mit einem Erweichungspunkt von 127 - 145 °C,
0,200 Gt des Veresterungsproduktes aus 1 Mol 2-(4-Hydroxyphenylethenyl)-4,6-bis-(trichlormethyl)-s-triazin und 1 Mol Naphthochinon-(1,2)-diazid-(2)-4-sulfonsäurechlorid,
0,070 Gt Kristallviolett
40,00 Gt Ethylenglykolmonomethylether und
60,00 Gt Tetrahydrofuran
Farbumschlag nach dem Belichten: Von tief dunkelblau nach hellblau.

## Patentansprüche

1. Lichtempfindliches Gemisch das im wesentlichen einen Naphthochinondiazidsulfonsäureester, ein in wäßrigalkalischen Lösungen lösliches, harzartiges Bindemittel und einen zur Salzbildung befähigten organischen Farbstoff enthält, dadurch gekennzeichnet, daß es einen 1,2-Naphthochinondiazidsulfonsäureester der allgemeinen Formel 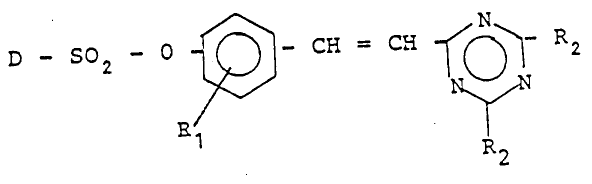 enthält, worin
D 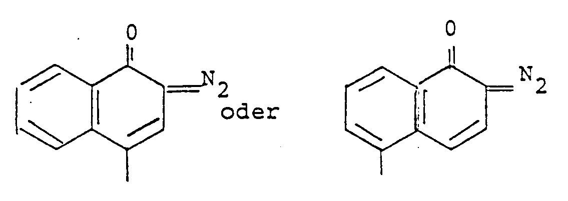
R₁ H, NO₂, Alkyl, Alkoxy mit jeweils bis zu 4 Kohlenstoffatomen, Halogen und/oder O-SO₂-D und
R₂ einen Trihalogenalkylrest
bedeuten.

2. Lichtempfindliches Gemisch nach Anspruch 1, dadurch gekennzeichnet, daß in der allgemeinen Formel
R₁ Wasserstoff, NO₂, Alkyl, Alkoxy, mit jeweils 1 oder 2 Kohlenstoffatomen, Chlor und/oder Brom und
R₂ Trichlormethyl
bedeuten.

3. Lichtempfindliches Gemisch nach Anspruch 1 oder 2, dadurch gekennzeichnet, daß der Naphthochinondiazidsulfonsäureester in einer Menge von 1 bis 30 Gewichtsprozent, bezogen auf das Gewicht des Gesamtfeststoffanteils des lichtempfindlichen Gemisches, vorhanden ist.

4. Lichtempfindliches Gemisch nach Anspruch 1, dadurch gekennzeichnet, daß das in wäßrig-alkalischen Lösungen lösliche Bindemittel ein Novolak ist.

5. Lichtempfindliches Gemisch nach Anspruch 1, dadurch gekennzeichnet, daß das in wäßrig-alkalischen Lösungen lösliche Bindemittel ein Polymerisat oder Copolymerisat einer mit einem mehrwertigen Phenol veresterten Acryl- bzw. Methacrylsäure ist.

6. Lichtempfindliches Gemisch nach Anspruch 1, dadurch gekennzeichnet, daß der Farbstoff ein Triphenylmethan-, Azo-, Phenazin-, Oxazin- oder Anthrachinonfarbstoff ist.

7. Lichtempfindliches Kopiermaterial aus einem Schichtträger und einer lichtempfindlichen Schicht, dadurch gekennzeichnet, daß die lichtempfindliche Schicht ein Gemisch nach Ansprüchen 1 bis 6 enthält oder daraus besteht.

## Claims

1. A photosensitive mixture essentially containing a naphthoquinonediazidesulfonic acid ester, a resinous binder which is soluble in aqueous-alkaline solutions, and an organic dye which is capable of salt formation, characterized in that it contains a 1,2-naphthoquinonediazidesulfonic acid ester of the general formula 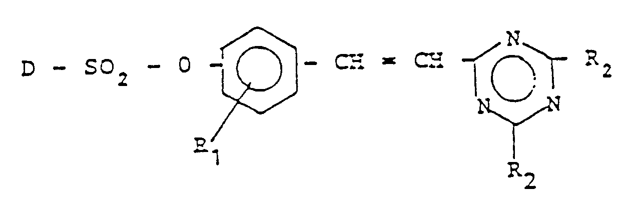 in which
D denotes 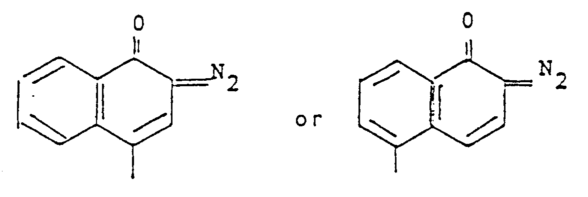
R₁ denotes hydrogen, NO₂, alkyl or alkoxy each having up to 4 carbon atoms, halogen and/or -O-SO₂-D, and
R₂ denotes a trihaloalkyl radical.

2. A photosensitive mixture as claimed in claim 1, characterized in that, in the general formula,
R₁ denotes hydrogen, NO₂, alkyl or alkoxy each having 1 or 2 carbon atoms, chlorine and/or bromine, and
R₂ denotes trichloromethyl.

3. A photosensitive mixture as claimed in claim 1 or 2, characterized in that the naphthoquinonediazidesulfonic acid ester is present in an amount from 1 to 30 percent by weight, relative to the weight of the total solids content of the photosensitive mixture.

4. A photosensitive mixture as claimed in claim 1, characterized in that the binder which is soluble in aqueous-alkaline solutions is a novolak.

5. A photosensitive mixture as claimed in claim 1, characterized in that the binder which is soluble in aqueous-alkaline solutions is a polymer or copolymer of an acrylic acid or methacrylic acid which has been esterified using a polyhydric phenol.

6. A photosensitive mixture as claimed in claim 1, characterized in that the dye is a triphenylmethane, azo, phenazine, oxazine or anthraquinone dye.

7. A photosensitive copying material comprising a coating base and a photosensitive coating, characterized in that the photosensitive coating contains or comprises a mixture as claimed in claims 1 to 6.

## Revendications

1. Composition photosensible qui contient essentiellement un ester d'acide naphtoquinonediazidesulfonique, un liant de type résine soluble dans des solutions aqueuses-alcalines et un colorant organique apte à la formation de sels, caractérisée en ce qu'elle contient un ester d'acide 1_{,}2-naphtoquinonediazidesulfonique de formule générale 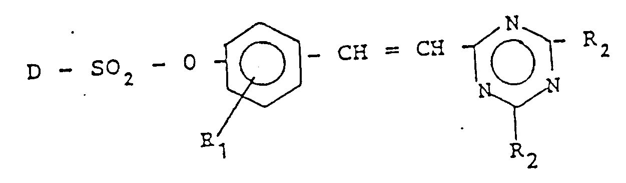 dans laquelle
D représente 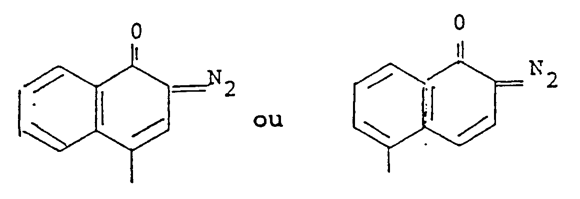
R₁ représente un atome d'hydrogène ou d'halogène ou un groupe NO₂, alkyle ou alcoxy ayant chacun jusqu'à 4 atomes de carbone et/ou O-SO₂-D et
R₂ représente un radical trihalogénoalkyle.

2. Composition photosensible selon la revendication 1, caractérisée en ce que, dans la formule générale
R₁ représente un atome d'hydrogène, de chlore et/ou de brome ou un groupe NO₂, alkyle ou alcoxy ayant chacun 1 ou 2 atomes de carbone, et
R₂ représente le groupe trichlorométhyle.

3. Composition photosensible selon la revendication 1 ou 2, caractérisée en ce que l'ester d'acide naphtoquinonediazidesulfonique est présent en une proportion de 1 à 30 % en poids, par rapport au poids de la fraction solide totale de la composition photosensible.

4. Composition photosensible selon la revendication 1, caractérisée en ce que le liant soluble dans des solutions aqueuses-alcalines est une Novolaque.

5. Composition photosensible selon la revendication 1, caractérisée en ce que le liant soluble dans des solutions aqueuses-alcalines est un polymère ou copolymère d'un acide acrylique ou méthacrylique estérifié par un phénol polyhydroxylé.

6. Composition photosensible selon la revendication 1, caractérisée en ce que le colorant est un colorant triphénylméthane, azoïque, phénazine, oxazine ou anthraquinonique.

7. Matériau de copie photosensible composé d'un support de couche et d'une couche photosensible, caractérisé en ce que la couche photosensible contient ou consiste en une composition selon les revendications 1 à 6.
